(19) Europäisches Patentamt
European Patent Office
Office européen des brevets

(11) EP 2 662 712 B1

(12) **EUROPEAN PATENT SPECIFICATION**

(45) Date of publication and mention
of the grant of the patent:
**05.11.2014 Bulletin 2014/45**

(21) Application number: **13167344.4**

(22) Date of filing: **10.05.2013**

(51) Int Cl.:
*G02B 5/30* (2006.01)      *G02F 1/13363* (2006.01)
*G02F 1/1335* (2006.01)      *B32B 37/20* (2006.01)
*B29D 11/00* (2006.01)      *H01L 27/32* (2006.01)
*B29C 55/02* (2006.01)

(54) **Multilayered optical film, manufacturing method thereof, and display device**

Mehrschichtige optische Folie, Herstellungsverfahren dafür, und Anzeigevorrichtung

Film optique multicouche, son procédé de fabrication et dispositif d'affichage

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **10.05.2012 KR 20120049647**

(43) Date of publication of application:
**13.11.2013 Bulletin 2013/46**

(73) Proprietors:
• **Samsung Electronics Co., Ltd
Gyeonggi-do 443-742 (KR)**
• **Cheil Industries Inc.
Gumi-si
Gyeongsangbuk-do 730-030 (KR)**

(72) Inventors:
• **In, Kyu Yeol
Seoul (KR)**
• **Kim, Hee Kyung
Gyeonggi-do (KR)**
• **Jung, Won Cheol
Seoul (KR)**
• **Kim, Hyung Jun
Gyeonggi-do (KR)**
• **Oh, Kyoung Ah
Seoul (KR)**
• **Lee, Moon Yeon
Gyeonggi-do (KR)**
• **Jung, Myung Sup
Gyeonggi-do (KR)**

(74) Representative: **Greene, Simon Kenneth
Elkington and Fife LLP
8 Pembroke Road
Sevenoaks Kent TN13 1XR (GB)**

(56) References cited:
**EP-A2- 0 916 989      EP-A2- 2 042 896
US-A1- 2011 025 966      US-B2- 7 473 446**

• **CHAO-TE LEE ET AL: "Designs of broadband and
wide-view patterned polarizers for stereoscopic
3D displays", OPTICS EXPRESS, vol. 18, no. 26,
20 December 2010 (2010-12-20), page 27079,
XP055071989, ISSN: 1094-4087, DOI: 10.1364/OE.
18.027079**

**Description**

**BACKGROUND OF THE INVENTION**

**(a) Field of the Invention**

Provided is an optical film, and in particular, a multilayered optical film, a manufacturing method thereof, and a display device.

**(b) Description of the Related Art**

Flat panel displays may be classified into emitting display devices that emit light by themselves and non-emitting display devices that require separate light sources. Optical compensation films such as phase difference films may be often used for improving image quality of the flat panel displays.

In an emitting display device, for example, an organic light emitting display, visibility and contrast ratio may be decreased due to reflection of external light by metal such as an electrode in the display device. In order to reduce such deterioration, a polarizing plate and a phase difference film are used to prevent the external light reflected in the display device from leaking out of the display device.

In a liquid crystal display ("LCD"), which is a kind of non-emitting display device, reflection of external light and sunglass effect may be reduced by converting linear polarization into circular polarization according to the types of the LCD including a transmissive type, a transflective type, and a reflective type, thereby improving the image quality of the LCD.

However, developed optical compensation film may have strong dependency on the wavelength of incident light such that the film may perform proper operation on the light having a peculiar wavelength but not on the light having other wavelengths.

Chao-Te Lee et al.: "Designs of broadband and wide-view patterned polarizers for stereoscopic 3D displays", OPTICS EXPRESS, vol. 18, no. 26, 20 December 2010, page 27079 discloses an optical film system wherein the out-of-plane retardation values of the respective retardation layers have the same sign.

**SUMMARY OF THE INVENTION**

An optical film according to an embodiment includes: a polarization layer; a first phase retardation layer having an optic axis at an angle in a range from 17 degrees to 27 degrees or from -27 degrees to -17 degrees with respect to a transmission axis of the polarization layer; and a second phase retardation layer having an optic axis at an angle in a range from 85 degrees to 95 degrees with respect to the transmission axis of the polarization layer, wherein the polarization layer, the first phase retardation layer, and the second phase retardation layer are stacked in sequence, the first phase retardation layer has an in-plane retardation value from about 240 nanometers (nm) to about 300 nm for incident light having a wavelength of about 550 nm (referred to as a "standard wavelength"), the second phase retardation layer has an in-plane retardation value of about 110 nm to about 160 nm for incident light having the standard wavelength, and an out-of-plane retardation value of the first phase retardation layer and an out-of-plane retardation value of the second phase retardation layer for incident light having the standard wavelength have opposite signs.

The out-of-plane retardation value of the first phase retardation layer for incident light having the standard wavelength may be greater than 0 nm and equal to or less than 300 nm, and the out-of-plane retardation value of the second phase retardation layer for incident light having the standard wavelength may be equal to or greater than -160 nm and less than 0 nm.

The out-of-plane retardation value of the first phase retardation layer for incident light having the standard wavelength may range from about 130 nm to about 250 nm, and the out-of-plane retardation value of the second phase retardation layer for incident light having the standard wavelength may range from about -130 nm to -50 nm.

The first phase retardation layer may have a short-wavelength dispersion value from about 1.00 to about 1.05, the second phase retardation layer may have a short-wavelength dispersion value from about 1.00 to about 1.20, the first phase retardation layer may have a long-wavelength dispersion value from about 0.95 to about 1.00, and the second phase retardation layer may have a long-wavelength dispersion value from about 0.85 to about 1.00.

At least one of the first phase retardation layer and the second phase retardation layer may include at least one of a cyclo-olefin polymer, polyacrylate, polycarbonate, polystyrene, polyethylene terephthalate, and a cellulose-based polymer.

The first phase retardation layer may include a cyclo-olefin polymer, and the second phase retardation layer may include polyacrylate.

The optical film may further include a passivation layer disposed opposite the second phase retardation layer relative to the first phase retardation layer.

The polarization layer may include a first roll film extending in a first direction substantially perpendicular to the transmission axis, the first phase retardation layer may include a second roll film extending in the first direction, having an optic axis at an angle in a range from about 17 degrees to about 27 degrees or from about -27 degrees to about -17 degrees with respect to a second direction substantially perpendicular to the first direction, and disposed on the first roll film, and the second phase retardation layer may include a third roll film extending in the first direction, having an optic axis at an angle in a range from about 85 degrees to about 95 degrees with respect to the second direction, and disposed on the second roll film.

The in-plane retardation value of the first phase retardation layer at the standard wavelength may be in a range from about 260 nanometers to about 280 nanometers, and the in-plane retardation value of the second phase retardation layer at the standard wavelength may be in a range from about 130 nanometers to about 140 nanometers.

The out-of-plane retardation value of the first phase retardation layer at the standard wavelength may be in a range from about 200 nanometers to about 230 nanometers, and the out-of-plane retardation value of the second phase retardation layer at the standard wavelength may be in a range from about -120 nanometers to about -90 nanometers.

The polarization layer, the first phase retardation layer, and the second phase retardation layer may be formed by roll-to-roll stretching.

A method of manufacturing an optical film according to an embodiment includes: unrolling rolls of a polarization layer, a first phase retardation layer, and a second phase retardation layer; proceeding unrolled portions of the polarization layer, the first phase retardation layer, and the second phase retardation layer in a proceeding direction; and moving closer the proceeding portions of the polarization layer, the first phase retardation layer, and the second phase retardation layer to each other to be stacked, wherein the polarization layer is stretched in the proceeding direction, the first phase retardation layer is stretched in a direction making an angle from about 63 degrees to about 73 degrees or about -73 degrees to about -63 degrees relative to the proceeding direction, the second phase retardation layer is stretched in a direction making an angle from about -5 degrees to about 5 degrees, and an out-of-plane retardation value of a stretched portion of the first phase retardation layer and an out-of-plane retardation value of a stretched portion of the second phase retardation layer have opposite signs.

The out-of-plane retardation value of the stretched portion of the first phase retardation layer for incident light having the standard wavelength may range from about 0 nm to about 300 nm, and the out-of-plane retardation value of the stretched portion of the second phase retardation layer for incident light having the standard wavelength may range from about -160 nm to 0 nm.

The out-of-plane retardation value of the stretched portion of the first phase retardation layer for incident light having the standard wavelength may range from about 130 nm to about 250 nm, and the out-of-plane retardation value of the stretched portion of the second phase retardation layer for incident light having the standard wavelength may range from about -130 nm to -50 nm.

At least one of the first phase retardation layer and the second phase retardation layer may include at least one of a cyclo-olefin polymer, polyacrylate, polycarbonate, polystyrene, polyethylene terephthalate, and a cellulose-based polymer.

A display device according to an embodiment includes: a display panel; and an optical film disposed on the display panel and including a first phase retardation layer and a second phase retardation layer, wherein the second phase retardation layer is disposed between the display panel and the first phase retardation layer, the first phase retardation layer has an in-plane retardation value from about 240 nanometers (nm) to about 300 nm for incident light having a wavelength of about 550 nm (referred to as a "standard wavelength"), the second phase retardation layer has an in-plane retardation value of about 110 nm to about 160 nm for incident light having the standard wavelength, an optic axis of the first phase retardation layer and an optic axis of the second phase retardation layer make an angle from about 63 degrees to about 73 degrees, and an out-of-plane retardation value of the first phase retardation layer and an out-of-plane retardation value of the second phase retardation layer for incident light having the standard wavelength have opposite signs.

The display device may further include a polarization layer disposed opposite the second phase retardation layer relative to the first phase retardation layer, and the polarization layer may have a transmission axis making an angle of from about 85 degrees to about 95 degrees with the optic axis of the second phase retardation layer.

The out-of-plane retardation value of the first phase retardation layer for incident light having the standard wavelength may range from about 0 nm to about 300 nm, and the out-of-plane retardation value of the second phase retardation layer for incident light having the standard wavelength may range from about -160 nm to 0 nm.

The out-of-plane retardation value of the first phase retardation layer for incident light having the standard wavelength may range from about 130 nm to about 250 nm, and the out-of-plane retardation value of the second phase retardation layer for incident light having the standard wavelength may range from about -130 nm to -50 nm.

At least one of the first phase retardation layer and the second phase retardation layer may include at least one of a cyclo-olefin polymer, polyacrylate, polycarbonate, polystyrene, polyethylene terephthalate, and a cellulose-based polymer.

## BRIEF DESCRIPTION OF THE DRAWINGS

FIG. 1 is a schematic sectional view of an optical film for a display device according to an embodiment.
FIG. 2 is a schematic sectional view of an optical film for a display device according to an embodiment.
FIG. 3 is a schematic plan view of the optical film shown in FIG. 2.
FIG. 4 is a schematic perspective view illustrating a method of manufacturing the optical film shown in FIG. 2 and FIG. 3 by roll-to-roll according to an embodiment.
FIG. 5 is a schematic sectional view of an optical film for a display device according to an embodiment.
FIG. 6 is a schematic sectional view of an organic light emitting display according to an embodiment.
FIG. 7 is a schematic sectional view of an experiment device including an optical film according to experimental examples and comparative examples.

## DETAILED DESCRIPTION OF THE EMBODIMENTS

Aspects of one or more of the embodiments will be described more fully hereinafter with reference to the accompanying drawings. As those skilled in the art would realize, the described embodiments may be modified in various different ways, all without departing from the spirit or scope. In the drawing, parts having no relationship with the explanation are omitted for clarity, and the same or similar reference numerals designate the same or similar elements throughout the specification.

It will be understood that when an element or layer is referred to as being "on," "connected to" or "coupled to" another element or layer, the element or layer can be directly on, connected or coupled to another element or layer or intervening elements or layers. In contrast, when an element is referred to as being "directly on," "directly connected to" or "directly coupled to" another element or layer, there are no intervening elements or layers present. As used herein, connected may refer to elements being physically and/or electrically connected to each other. As used herein, the term "and/or" includes any and all combinations of one or more of the associated listed items.

It will be understood that, although the terms first, second, third, etc., may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the invention.

Spatially relative terms, such as "lower," "upper" and the like, may be used herein for ease of description to describe the relationship of one element or feature to another element(s) or feature(s) as illustrated in the figures. It will be understood that the spatially relative terms are intended to encompass different orientations of the device in use or operation, in addition to the orientation depicted in the figures. For example, if the device in the figures is turned over, elements described as "lower" relative to other elements or features would then be oriented "upper" relative to the other elements or features. Thus, the exemplary term "lower" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of the invention. As used herein, the singular forms "a," "an" and "the" are intended to include the plural forms as well, unless the context clearly indicates otherwise. It will be further understood that the terms "comprises," "comprising," "includes" and/or "including," when used in this specification, specify the presence of stated features, integers, steps, operations, elements, and/or components, but do not preclude the presence or addition of one or more other features, integers, steps, operations, elements, components, and/or groups thereof.

Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, the invention will be described in detail with reference to the accompanying drawings.

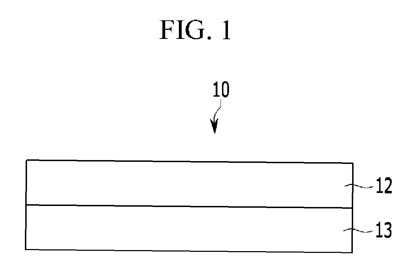

An optical film for a display device according to an embodiment is described in detail with reference to FIG. 1.

FIG. 1 is a schematic sectional view of an optical film for a display device according to an embodiment.

Referring to FIG. 1, an optical film 10 for a display device according to an embodiment includes a first phase retardation layer 12 and a second phase retardation layer 13 stacked from top to bottom.

An optic axis of the first phase retardation layer 12 and an optic axis of the second phase retardation layer 13 may make an angle from about 63 degrees to about 73 degrees or from about -63 degrees to about -73 degrees.

According to an embodiment, the first phase retardation layer 12 may have an in-plane retardation (Re) value from about 240 nanometers (nm) to about 300 nm, for example, from about 260 nm to about 280 nm for incident light having a wavelength of about 550 nm that will be referred to as a "standard wavelength." The in-plane retardation Re is given by Re = $(n_x - n_y) \times d$, where d denotes a thickness of the layer 12, and $n_x$ and $n_y$ denote refractive coefficients in two orthogonal directions in a plane substantially perpendicular to a thickness direction. Therefore, the phase retardation layer 12 may serve as a half-wave plate.

The second phase retardation layer 13 may have an in-plane retardation value of about 110 nm to about 160 nm, for example, about 130 nm to about 140 nm for incident light having the standard wavelength. Therefore, the second phase retardation layer 13 may serve a quarter-wave plate.

As described above, the optical film 10 according to an embodiment is regarded as a stack of a quarter-wave plate and a half-wave plate, and thus may have a function of circular polarization.

According to an embodiment, an out-of-plane retardation (Rth) value of the first phase retardation layer 12 and an out-of-plane retardation value of the second phase retardation layer 13 for incident light having the standard wavelength may have opposite signs. For example, the out-of-plane retardation value of the first phase retardation layer 12 for incident light having the standard wavelength may be positive, and the out-of-plane retardation value of the second phase retardation layer 13 for incident light having the standard wavelength may be negative. The out-of-plane retardation Rth is given by Rth = $\{[(n_x + n_y)/2] - n_z\} \times d$, where d denotes the thickness of the layer 110, $n_z$ denotes a refractive coefficient in the thickness direction, and $n_x$ and $n_y$ denote refractive coefficients in two orthogonal directions in a plane substantially perpendicular to the thickness direction.

According to an embodiment, an absolute value of the out-of-plane retardation of the first phase retardation layer 12 for incident light having the standard wavelength may be equal to or lower than about 300 nm, and an absolute value of the out-of-plane retardation of the second phase retardation layer 13 for incident light having the standard wavelength may be equal to or lower than about 160 nm.

According to an embodiment, an out-of-plane retardation value of the first phase retardation layer 12 for incident light having the standard wavelength may range from about 0 nm to about 300 nm, for example, from about 130 nm to about 250 nm or from about 200 nm to about 230 nm. An out-of-plane retardation value of the second phase retardation layer 13 for incident light having the standard wavelength may range from about -160 nm to 0 nm, for example, from about -130 nm to about -50 nm or from about -120 nm to about - 90 nm.

According to an embodiment, the first phase retardation layer 12 may have a short-wavelength dispersion value from about 1.00 to about 1.05, and the second phase retardation layer 13 may have a short-wavelength dispersion value from about 1.00 to about 1.20. The short-wavelength dispersion denotes a retardation value for incident light having a wavelength of about 450 nm divided by a retardation value for incident light having the standard wavelength.

According to an embodiment, the first phase retardation layer 12 may have a long-wavelength dispersion value from about 0.95 to about 1.00, and the second phase retardation layer 13 may have a long-wavelength dispersion value from about 0.85 to about 1.00. The long-wavelength dispersion denotes a retardation value for incident light having a wavelength of about 650 nm divided by a retardation value for incident light having the standard wavelength.

According to an embodiment, at least one of the first phase retardation layer 12 and the second phase retardation layer 13 may include at least one of a cyclo-olefin polymer, polyacrylate, polycarbonate (PC), polystyrene (PSt), polyethylene terephthalate (PET), and a cellulose-based polymer. For example, the first phase retardation layer 12 may include a cyclo-olefin polymer, and the second phase retardation layer 13 may include polyacrylate. The phase retardation layer 12 or 13 including polystyrene, polyacrylate, or a cellulose-based polymer may have a negative value of the out-of-plane retardation for incident light having the standard wavelength.

According to an embodiment, at least one of the first phase retardation layer 12 and the second phase retardation layer 13 may be formed by stretching. The first phase retardation layer 12 and the second phase retardation layer 13 may be stacked in roll-to-roll.

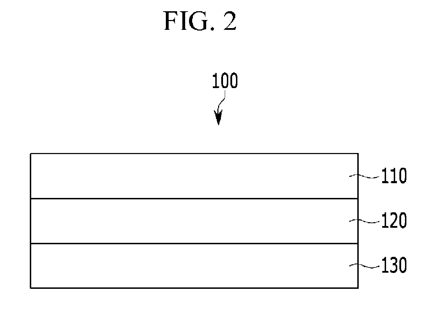

An optical film for a display device according to an embodiment is described in detail with reference to FIG. 2 to FIG. 4.

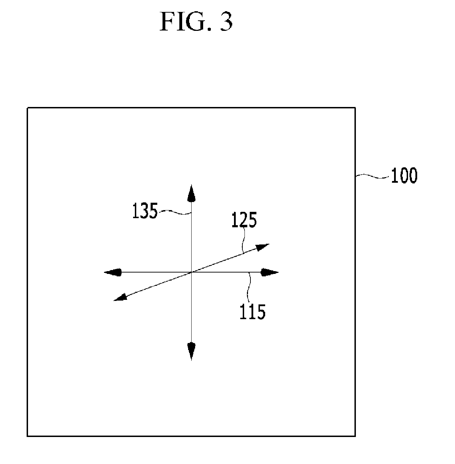

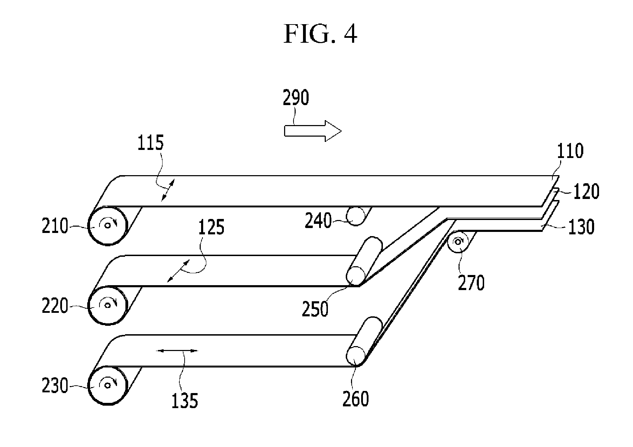

FIG. 2 is a schematic sectional view of an optical film for a display device according to an embodiment, FIG. 3 is a schematic plan view of the optical film shown in FIG. 2, and FIG. 4 is a schematic perspective view illustrating a method of manufacturing the optical film shown in FIG. 2 and FIG. 3 by roll-to-roll according to an embodiment.

Referring to FIG. 2 and FIG. 3, an optical film 100 for a display device according to an embodiment includes a polarization layer 110, a first phase retardation layer 120, and a second phase retardation layer 130 stacked from top to bottom. The optical film 100 may further include an additional layer (not shown) disposed on the polarization layer 110, and the additional layer may protect the polarization layer 110 or may reduce or inhibit reflection or dazzling of light.

The polarization layer 110 may be a linear polarizer configured to convert the polarization of incident light into linear polarization, and may include poly-vinyl alcohol (PVA) doped with iodine, for example.

The first phase retardation layer 120 may have an in-plane retardation value from about 240 nm to about 300 nm, for example, from about 260 nm to about 280 nm for incident light having the standard wavelength. Therefore, the phase retardation layer 120 may serve as a half-wave plate.

The second phase retardation layer 130 may have an in-plane retardation value of about 110 nm to about 160 nm, for example, about 130 nm to about 140 nm for incident light having the standard wavelength. Therefore, the second phase retardation layer 130 may serve a quarter-wave plate.

An optic axis 125 of the first phase retardation layer 120 and an transmission axis 115 of the polarization layer 110 may make an angle from about 17 degrees to about 27 degrees or from about -27 degrees to about -17 degrees. An optic axis 135 of the second phase retardation layer 130 and the transmission axis 115 of the polarization layer 110 may make an angle from about 85 degrees to about 95 degrees. The optic axis 125 of the first phase retardation layer 120 and optic axis 135 of the second phase retardation layer 13 may make an angle from about 63 degrees to about 73 degrees or from about -63 degrees to about -73 degrees. Since an absorption axis of the polarization layer 110 is substantially perpendicular to the transmission axis 115 of the polarization layer 110, an angle made by the optic axis 125 of the first phase retardation layer 120 and the absorption axis of the polarization layer 110 may range from about 63 degrees to about 73 degrees or from about -73 degrees to about -63 degrees, and an angle made by the optic axis 135 of the second phase retardation layer 130 and the absorption axis of the polarization layer 110 may range from about -5 degrees to about 5 degrees.

An optical film including a half-wave plate and a quarter-wave plate may convert linear polarization into circular polarization when the optical film satisfies a relation $\theta_1 = 2\theta_0 + 45°$, where $\theta_0$ denotes an angle made by a slow axis of the half-wave plate with a predetermined reference direction, and $\theta_1$ denotes an angle made by a slow axis of the quarter-wave plate with the predetermined reference direction.

As described above, the optical film according to an embodiment is formed by stacking the first phase retardation layer 120 of a half-wave plate and the second phase retardation layer 130 of a quarter-wave plate with the above-described angle such that the optical film have circular polarization function.

According to an embodiment, an out-of-plane retardation value of the first phase retardation layer 120 and an out-of-plane retardation value of the second phase retardation layer 130 for incident light having the standard wavelength may have opposite signs. For example, the out-of-plane retardation value of the first phase retardation layer 120 for incident light having the standard wavelength may be positive, and the out-of-plane retardation value of the second phase retardation layer 130 for incident light having the standard wavelength may be negative.

According to an embodiment, an absolute value of the out-of-plane retardation of the first phase retardation layer 120 for incident light having the standard wavelength may be equal to or lower than about 300 nm, and an absolute value of the out-of-plane retardation of the second phase retardation layer 130 for incident light having the standard wavelength may be equal to or lower than about 160 nm.

According to an embodiment, an out-of-plane retardation value of the first phase retardation layer 120 for incident light having the standard wavelength may range from about 0 nm to about 300 nm, for example, from about 130 nm to about 250 nm or from about 200 nm to about 230 nm. An out-of-plane retardation value of the second phase retardation layer 130 for incident light having the standard wavelength may range from about -160 nm to 0 nm, for example, from about -130 nm to about -50 nm or from about -120 nm to about -90 nm.

According to an embodiment, the first phase retardation layer 120 may have a short-wavelength dispersion value from about 1.00 to about 1.05, and the second phase retardation layer 130 may have a short-wavelength dispersion value from about 1.00 to about 1.20.

According to an embodiment, the first phase retardation layer 120 may have a long-wavelength dispersion value from about 0.95 to about 1.00, and the second phase retardation layer 130 may have a long-wavelength dispersion value from about 0.85 to about 1.00.

According to an embodiment, at least one of the first phase retardation layer 120 and the second phase retardation layer 130 may include at least one of a cyclo-olefin polymer, polyacrylate, polycarbonate, polystyrene, polyethylene terephthalate, and a cellulose-based polymer. For example, the first phase retardation layer 120 may include a cyclo-olefin polymer, and the second phase retardation layer 130 may include polyacrylate. The phase retardation layer 120 or 130 including polystyrene, polyacrylate, or a cellulose-based polymer may have a negative value of the out-of-plane retardation for incident light having the standard wavelength.

According to an embodiment, at least one of the first phase retardation layer 120 and the second phase retardation layer 130 may be formed by stretching. The polarization layer 110, the first phase retardation layer 120, and the second phase retardation layer 130 may be stacked in roll-to-roll.

According to an embodiment, the first phase retardation layer 120 may be formed of a positively birefringent material that has a slow axis representing a maximum refractive coefficient in a stretching direction. For example, the first phase retardation layer 120 may include at least one of a cyclo-olefin polymer, polycarbonate, polyethylene terephthalate, and a cellulose-based polymer. An unstretched film including a positively birefringent material may be prepared and rolled to form a roll. The rolled film may be unrolled and proceed. The proceeding film may be stretched in a direction oblique to a proceeding direction, and may be rolled again to form a roll of the first phase retardation layer 120 having an oblique slow axis. The oblique stretching may be performed with adjusting the stretching rate to obtain a desired retardation value and with adjusting the stretching direction so that the slow axis of the first phase retardation layer 120 may make an angle of from about 17 degrees to about 27 degrees or from about -27 degrees to about -17 degrees relative to a direction substantially perpendicular to the proceeding direction of the proceeding film. A method of oblique stretching is disclosed in Korean Patent Application Publication No. 2008-0071150, the content of which in its entirety is herein incorporated by reference.

According to an embodiment, the second phase retardation layer 130 may be formed of a negatively birefringent material that has a slow axis representing a maximum refractive coefficient in a direction substantially perpendicular to a stretching direction. For example, the second phase retardation layer 130 may include a polymer including polystyrene, acrylic polymer, PC, acrylate-styrene copolymer, and a combination of at least two of the above-listed materials. An unstretched film including a negatively birefringent material may be prepared and rolled to form a roll. The rolled film may be unrolled and proceed. The proceeding film may be stretched in a direction substantially perpendicular to a proceeding direction, and may be rolled again to form a roll of the second phase retardation layer 130 having a slow axis substantially parallel to the proceeding direction of the proceeding film. The stretching may be performed with adjusting the stretching rate to obtain a desired retardation value and with adjusting the stretching direction so that the slow axis of the second phase retardation layer 130 may make an angle of from about 85 degrees to about 95 degrees relative to the proceeding direction of the proceeding film.

Referring to FIG. 4, a plurality of rolls 210, 220 and 230 of the stretched polarization layer 110, the stretched first phase retardation layer 120, and the stretched second phase retardation layer 130 may be prepared. The films of the polarization layer 110, the first phase retardation layer 120, and the second phase retardation layer 130 in the rolls 210, 220 and 230 may be unrolled and proceeded in a direction 290. The polarization layer 110 may have a stretching direction substantially parallel to the proceeding direction 290 and a transmission axis 115 substantially perpendicular to the stretching direction. The first phase retardation layer 120 may have a stretching direction and a slow axis, both making an angle from about 63 degrees to about 73 degrees or from about -73 degrees to about -63 degrees relative to the proceeding direction 290. The second phase retardation layer 130 may have a stretching direction and a slow axis, both making an angle from about -5 degrees to about 5 degrees relative to the proceeding direction 290.

The films of the layers 110, 120 and 130 may be gathered in a place by a lamination roller 270, and may be laminated or stacked and attached to one another. Reference numerals 240, 250 and 260 shown in FIG. 4 denote subsidiary rollers configured to maintain the films of the layers 110, 120 and 130 flat.

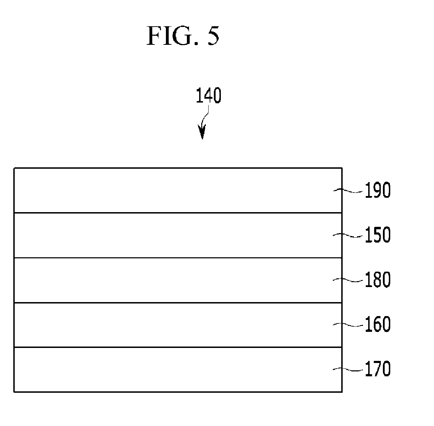

An optical film for a display device according to an embodiment is described in detail with reference to FIG. 5.

FIG. 5 is a schematic sectional view of an optical film for a display device according to an embodiment.

Referring to FIG. 5, an optical film 140 for a display device according to an embodiment has a structure similar to the optical film 100 shown in FIG. 2. In detail, the optical film 140 includes a polarization layer 150, a first phase retardation layer 160, and a second phase retardation layer 170 stacked from top to bottom. However, the optical film 140 further includes a first passivation layer 180 and a second passivation layer 190. The first passivation layer 180 is disposed between the polarization layer 150 and the first phase retardation layer 160, and the second passivation layer 190 is disposed on the polarization layer 150.

The first and second passivation layers 180 and 190 are configured to protect the polarization layer 150, and may include triacetyl cellulose (TAC), for example.

The second passivation layer 190, which is disposed on the top of the optical film 140, may have characteristics of anti-reflection, low-reflection, anti-glare, or hard coating.

One of the first passivation layer 180 and the second passivation layer 190 may be omitted.

The polarization layer 150 and the first and second phase retardation layers 160 and 170 may be similar to those shown in FIG. 2, and the detailed description thereof is omitted.

The optical films 10, 100 and 140 shown in FIG. 1, FIG. 2, and FIG. 5 may be used in a display device, in particular, a flat panel display including a liquid crystal display and an organic light emitting display.

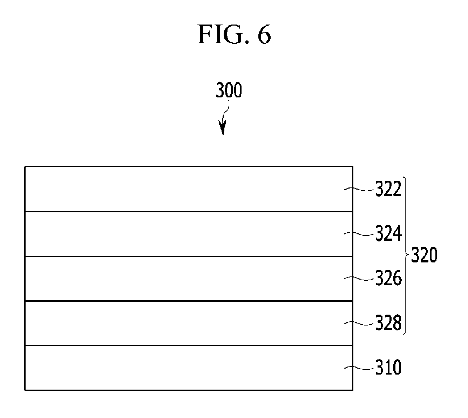

An organic light emitting display according to an embodiment is described in detail with reference to FIG. 6.

FIG. 6 is a schematic sectional view of an organic light emitting display according to an embodiment.

Referring to FIG. 6, an organic light emitting display 300 according to an embodiment includes an organic light emitting panel 310 configured to display images and an optical film 320 attached to the organic light emitting panel 310.

The organic light emitting panel 310 may include a pair of electrodes (not shown) facing each other and a light emitting layer (not shown) disposed between the electrodes and including an organic light emitting material.

The optical film 320 may include a passivation layer 322, a polarization layer 324, a first phase retardation layer 326, and a second phase retardation layer 328 stacked from top to bottom.

The polarization layer 324 and the first and second phase retardation layers 326 and 328 may have substantially the same characteristics as the polarization layer 110 and the first and second phase retardation layers 120 and 130, respectively, shown in FIG. 2. For example, the polarization layer 324 may be a linear polarizer, the first phase retardation layer 326 may be a half-wave plate, and the second phase retardation layer 328 may be a quarter-wave plate.

The passivation layer 322 may protect the polarization layer 324, and may include TAC, for example. According to an alternative embodiment, the passivation layer 322 may have characteristics of anti-reflection, low-reflection, anti-glare, or hard coating.

External light incident on the organic light emitting display 300 may enter into the organic light emitting panel 310 through the optical film 320, and may be reflected by a reflective member, for example, an electrode of the organic light emitting panel 310. In this case, the external light may be linearly polarized after passing through the polarization layer 324, and then may experience a retardation of about a half wavelength when passing through the first phase retardation layer 326 such that the polarization direction is changed. Thereafter, the light may experience a retardation of about a quarter wavelength when passing through the second phase retardation layer 328 such that the linear polarization may be converted into a circular polarization. After passing through the second phase retardation layer 328, the circularly polarized external light may be reflected by the reflective member of the organic light emitting panel 310, and then may back towards the second phase retardation layer 328 again. The reflected light may also experience a retardation of about a quarter wavelength when secondly passing through the second phase retardation layer 328 such that the circular polarization of the light may be converted back into a linear polarization. The linearly-polarized light may also experience a retardation of about a half wavelength when secondly passing through the first phase retardation layer 326 such that the polarization direction of the light may be changed. As a result, the external light initially incident on the organic light emitting panel 310 after firstly passing through the polarization layer 324 may pass through (the first phase retardation layer 326 and) the second phase retardation layer 328 twice such that a polarization axis of the external light rotates about 90 degrees when the external light reaches the polarization layer 324 again. As a result, even when external light is reflected in the organic light emitting display 300 including the organic light emitting panel 310, leaking of the reflected light from the organic light emitting display 300 is reduced or effectively prevented, thereby improving the image quality of the organic light emitting display 300.

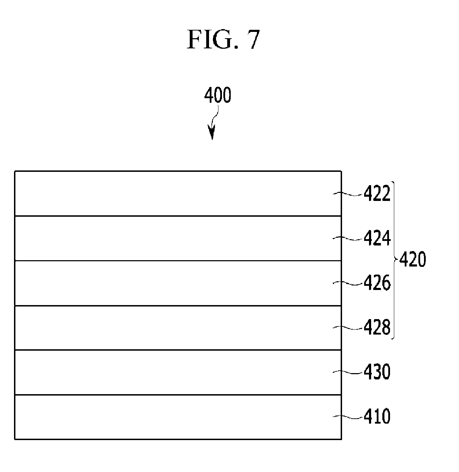

Optical films according to experimental examples and comparative examples are described in detail with reference to FIGS. 7 to 15.

FIG. 7 is a schematic sectional view of an experiment device including an optical film according to experimental examples and comparative examples.

Referring to FIG. 7, an optical film 420 including a passivation layer 422, a polarization layer 424, a first phase retardation layer 426, and a second phase retardation layer 428 was attached to a reflector 410 with the adhesion layer 430, and reflectance and color shift of the combined device were measured.

Manufacturing First Phase Retardation Layer 426

A cyclo-olefin polymer ("COP") film (ZEONOR produced by Zeon Chemicals L.P. in Japan) was obliquely stretched in a direction at an angle of about 22.5 degrees with respect to a transverse direction that is substantially perpendicular to a proceeding direction of the COP film. The oblique stretch was performed such that an edge of the COP film was stretched in the transverse direction and an opposite edge of the COP film was stretched in the direction at an angle of about 22.5 degrees with respect to the transverse direction. For Experimental Examples 1 to 7, the in-plane retardation values and the out-of-plane retardation values of the stretched COP film (i.e., the first phase retardation film 426) shown in Table 1 were obtained at the temperature ranging from about 105 °C to about 125 °C during the stretch and with the stretching ratio ranging from about 1.3 to about 3. A surface of the first phase retardation film 426 was primer treated with silicone particles to enhance the strength of adhesion in a following process. A thickness of the first phase retardation film 426 was about 45 microns ($\mu$m).

Manufacturing Second Phase Retardation Layer 428

A styrene-butadiene rubber ("SBR") toughened poly(methyl methacrylate) (PMMA) film having negative birefringence (produced by LG CHEM, LTD. in Korea) was stretched in the transverse direction to form a second phase retardation layer 428. The SBR toughened PMMA film includes a PMMA film and SBR particles in the PMMA film. For Experimental Examples 1 to 7, the in-plane retardation values and the out-of-plane retardation values of the second phase retardation layer 428 shown in Table 1 were obtained at the temperature ranging equal to or lower than about 110 °C during the stretch. A thickness of the second phase retardation layer 428 was about 55 $\mu$m.

Manufacturing Polarization Layer 424

A PVA film (PS60 produced by KURARAY CO., LTD. in Japan) was dyed with iodine at a temperature of about 27 degrees, and, thereafter, was stretched in the proceeding direction at a temperature of about 57 °C and at a stretch ratio of about six (6) to form a polarization layer 424 with a thickness of about 22 $\mu$m.

First Lamination

An aquatic adhesive of a PVA solution including water at a ratio of about 99 wt% was coated on both surfaces of the above-described polarization layer 424, and a thickness of each of the aquatic adhesive was about 200 nm. The first phase retardation layer 426, the polarization layer 424, and a passivation layer 422 were laminated with the adhesive to form a first laminated film. The passivation layer 422 was a low reflectance ("LR") film (DSG03SC-60 produced by Dai Nippon Printing ("DNP") CO., LTD in Japan) having a thickness of about 60 $\mu$m. The LR film includes a TAC base substrate and a plurality of hollow silica particles coated on the base substrate. The first phase retardation layer 426 was aligned such that the primer treated surface faces the polarization layer 424.

A surface opposite the primer-treated surface of the first phase retardation layer 426 of the first laminated film was corona treated to enhance the strength of adhesion, and was coated with an epoxy resin adhesive having a thickness of about 25 $\mu$m. Thereafter, a separator was attached to the epoxy resin adhesive.

Second Lamination

The separator on the first laminated film was removed, and the first laminated film and the second phase retardation layer 428 were laminated with the epoxy resin adhesive on the first laminated film to form an optical film 420.

Coating of Adhesion Layer 430 and Film Cutting

An adhesion layer 430 of epoxy resin adhesive having a thickness of about 25 $\mu$m was coated on the second phase retardation layer 428 of the optical film 420 manufactured by the second lamination, and a separator was attached onto the adhesion layer 430. Thereafter, the optical film 420 with the adhesion layer 430 and the separator was aged. Next, the optical film 420 with the adhesion layer 430 was cut into pieces with a moving cutter.

Measurement of In-plane Retardation and Out-of-plane Retardation

The in-plane retardation values and in-plane retardation values of the first phase retardation layer 426 and the second phase retardation layer 428 were measured using Axoscan (produced by Axometrix, Inc.). The in-plane retardation values were scanned with varying the azimuthal angle from about zero to about 360 degrees to find out a direction in which the in-plane retardation value was a maximum. The direction of the maximum retardation value was determined as an optic axis, i.e., the slow axis of a layer 426 or 428. The refractive coefficient in the optical axis is defined as nx.

Measurement and Calculation of Reflective Characteristics

A black plate and a mirror as a reflector 410 were prepared, and light from D65 standard light source was reflected by the black plate and the reflector 410 to measure luminance of the reflected light using EZContrast (produced by ELDIM in France).

Next, the optical film 420 was attached on the reflector 410 with the adhesion layer 430, and the reflected-light luminance of the optical film 420 was measured.

At this time, for a given polar angle, the reflected-light luminance was measured with varying an azimuthal angle by a unit of about one degree from about zero to about 360 degrees, and the measured luminance values were averaged.

A reflectance of the optical film 420 was given by:

$$\text{Reflectance} = ((\text{average luminance of optical film}) - (\text{average luminance of black plate})) / ((\text{average luminance of reflector}) - (\text{average luminance of black plate})) \times 100$$

The measurement was repeatedly performed for various polar angles to obtain reflectance for corresponding polar angles.

The color shift was obtained by measuring color value of the reflected light for the optical film 420, converting the color value into a color coordinate in a Lab coordinate system, and calculating a distance $(=(a^{*2}+b^{*2})^{1/2})$ of the color coordinate from an origin $((a^*,b^*)=(0,0))$.

The above-described processes were repeatedly performed for each of Experimental Examples 1 to 7.

Comparative Example 1

The above-described processes were applied to Comparative Example 1 except that a material for the second phase retardation layer 428 was COP that was substantially the same as the material for the first phase retardation layer 426.

Comparative Example 2

A (second) phase retardation layer 428 was formed by stretching a COP film (ZEONOR produced by Zeon Chemicals L.P. in Japan) in the transverse direction. A polarization layer 424 was formed by the above-described process for Experimental Examples, and cut into pieces. The piece of the polarization layer 424, the phase retardation layer 428, and a passivation layer 422 were aligned such that the optic axis of the phase retardation layer 428 makes an angle of about 45 degrees with the transmission axis of the piece of the polarization layer 424, and laminated like the process of the first lamination. Following processes were substantially the same as the above-described processes for Experimental Examples.

Results

The experimental conditions and results for the optical film 420 according to the Experimental Example and Comparative Examples are shown in Table 1.

Table 1

|  | 1st layer | | 2nd layer | | Angle | | Reflectance (%) | | Color Shift | |
|---|---|---|---|---|---|---|---|---|---|---|
|  | Re | Rth | Re | Rth | 1st layer | 2nd layer | front | lateral | front | lateral |
| Experimental | 260 | 218 | 130 | -100 | 22.5 | 90 | 1.8 | 4.4 | 6.8 | 10.3 |
| Experimental | 265 | 209 | 130 | -100 | 22.5 | 90 | 1.8 | 4.8 | 5.6 | 10.2 |
| Experimental | 270 | 212 | 130 | -100 | 22.5 | 90 | 1.8 | 5.1 | 4.5 | 10.8 |
| Experimental | 275 | 218 | 130 | -100 | 22.5 | 90 | 1.8 | 5.2 | 5.3 | 11.1 |
| Experimental | 280 | 226 | 130 | -100 | 22.5 | 90 | 1.9 | 5.3 | 4.5 | 10.9 |
| Experimental | 260 | 218 | 135 | -110 | 22.5 | 90 | 2.2 | 4.6 | 9.1 | 10.7 |
| Experimental | 260 | 218 | 140 | -113 | 22.5 | 90 | 2.7 | 4.6 | 9.1 | 10.4 |
| Comparative | 280 | 140 | 140 | 70 | 22.5 | 90 | 3.2 | - | 19.5 | - |
| Comparative | - | - | 140 | 70 | - | 45 | 1.9 | - | 18.7 | - |

In Table 1, "1st layer" denotes the first phase retardation layer 426, "2nd layer" denotes the second phase retardation layer 428, and "Angle" denotes an angle of the slow axis of the first phase retardation layer 426 or the second phase retardation layer 428 with respect to the transmission axis of the polarization layer 424. The reflectance and color shift were shown for a front direction at a polar angle of about 8 degrees and a lateral direction at a polar angle of about 45 degrees.

Referring to Table 1, in Experimental Examples 1 to 7, the front reflectance was low to show values less than about 3 %, and the lateral reflectance was also low to exhibit values less than about 6 %. In view of color shift, the value for the front direction was less than 10, which is low, and the value for the lateral direction was less than 12, which is also low to exhibit nearly black.

in Comparative Examples 1 and 2, the front reflectance was low to exhibit values of less than about 3.2 %. However, the color shift for the front direction is very high to show values of about 18.7 and about 19.5. Therefore, the color of the reflected light may be very different from the color of the light before the reflection in the Comparative Examples.

While this disclosure has been described in connection with what is presently considered to be practical exemplary embodiments, it is to be understood that the invention is not limited to the disclosed embodiments, but, on the contrary, is intended to cover various modifications and equivalent arrangements.

**<Description of symbols>**

10, 100, 150, 320, 420: optical film
110, 160, 324, 424: polarization layer
115: transmission axis of polarization layer
12, 120, 160, 326, 426: first phase retardation layer
125: slow axis (or optic axis) of first phase retardation layer
13, 130, 170, 328, 428: second phase retardation layer
135: slow axis (or optic axis) of second phase retardation layer
180, 190, 322, 422: passivation layer
210, 220, 230, 240, 250, 260, 270: roll
300, 400: organic light emitting display
310, 410: organic light emitting panel
430: adhesion layer

**Claims**

1. An optical film comprising:

   a polarization layer;
   a first phase retardation layer having an optic axis at an angle in a range from 17 degrees to 27 degrees or from -27 degrees to -17 degrees with respect to a transmission axis of the polarization layer; and
   a second phase retardation layer having an optic axis at an angle in a range from 85 degrees to 95 degrees with respect to the transmission axis of the polarization layer,
   wherein the polarization layer, the first phase retardation layer, and the second phase retardation layer are stacked in sequence,
   the first phase retardation layer has an in-plane retardation value from 240 nm to 300 nm for incident light having a standard wavelength of 550 nm, , the second phase retardation layer has an in-plane retardation value of 110 nm to 160 nm for incident light having the standard wavelength, and
   an out-of-plane retardation value of the first phase retardation layer and an out-of-plane retardation value of the second phase retardation layer for incident light having the standard wavelength have opposite signs.

2. The optical film of claim 1, wherein the out-of-plane retardation value of the first phase retardation layer for incident light having the standard wavelength is greater than 0 nm and equal to or less than 300 nm, and
   the out-of-plane retardation value of the second phase retardation layer for incident light having the standard wavelength is equal to or greater than -160 nm and less than 0 nm.

3. The optical film of claim 2, wherein the out-of-plane retardation value of the first phase retardation layer for incident light having the standard wavelength ranges from 130 nm to 250 nm, and
   the out-of-plane retardation value of the second phase retardation layer for incident light having the standard wavelength ranges from -130 nm to -50 nm.

4. The optical film of claim 3, wherein the first phase retardation layer has a short-wavelength dispersion value from 1.00 to 1.05,
   the second phase retardation layer has a short-wavelength dispersion value from 1.00 to 1.20,
   the first phase retardation layer has a long-wavelength dispersion value from 0.95 to 1.00, and
   the second phase retardation layer has a long-wavelength dispersion value from 0.85 to 1.00.

5. The optical film of any preceding claim, wherein at least one of the first phase retardation layer and the second phase retardation layer comprises at least one of a cyclo-olefin polymer, polyacrylate, polycarbonate, polystyrene, polyethylene terephthalate, and a cellulose-based polymer.

6. The optical film of claim 7, wherein the first phase retardation layer comprises a cyclo-olefin polymer, and the second phase retardation layer comprises polyacrylate.

7. The optical film of any preceding claim, further comprising a passivation layer disposed opposite the second phase retardation layer relative to the first phase retardation layer.

8. The optical film of any preceding claim, wherein
the polarization layer includes a first roll film extending in a first direction substantially perpendicular to the transmission axis,
the first phase retardation layer includes a second roll film extending in the first direction, having an optic axis at an angle in a range from 17 degrees to 27 degrees or -27 degrees to -17 degrees with respect to a second direction perpendicular to the first direction, and disposed on the first roll film, and
the second phase retardation layer includes a third roll film extending in the first direction, having an optic axis at an angle in a range from 85 degrees to 95 degrees with respect to the second direction, and disposed on the second roll film.

9. The optical film of claim 1, wherein
the in-plane retardation value of the first phase retardation layer at the standard wavelength is in a range from 260 nm to 280 nm, and
the in-plane retardation value of the second phase retardation layer at the standard wavelength is in a range from about 130 nm to about 140 nm.

10. The optical film of claim 1, wherein
the out-of-plane retardation value of the first phase retardation layer at the standard wavelength is in a range from about 200 nm to about 230 nm, and
the out-of-plane retardation value of the second phase retardation layer at the standard wavelength is in a range from about -120 nm to about -90 nm.

11. A display device comprising:

a display panel; and
an optical film according to any preceding claim disposed on the display panel.

12. A method of manufacturing an optical film, the method comprising:

unrolling rolls of a polarization layer, a first phase retardation layer, and a second phase retardation layer;
proceeding unrolled portions of the polarization layer, the first phase retardation layer, and the second phase retardation layer in a proceeding direction; and
moving closer the proceeding portions of the polarization layer, the first phase retardation layer, and the second phase retardation layer to each other to be stacked,
wherein the polarization layer is stretched in the proceeding direction,
the first phase retardation layer is stretched in a direction making an angle from 63 degrees to 73 degrees or -73 degrees to -63 degrees relative to the proceeding direction,
the second phase retardation layer is stretched in a direction making an angle from -5 degrees to 5 degrees relative to the proceeding direction, and
an out-of-plane retardation value of a stretched portion of the first phase retardation layer at a standard wavelength of about 550 nanometers and an out-of-plane retardation value of a stretched portion of the second phase retardation layer at the standard wavelength have opposite signs.

13. The method of claim 12, wherein the out-of-plane retardation value of the stretched portion of the first phase retardation layer for incident light having the standard wavelength is greater than 0 nm and equal to or less than 300 nm, and
the out-of-plane retardation value of the stretched portion of the second phase retardation layer for incident light having the standard wavelength is equal to or greater than -160 nm and less than 0 nm.

14. The method of claim 13, wherein the out-of-plane retardation value of the stretched portion of the first phase retardation layer for incident light having the standard wavelength ranges from 130 nm to 250 nm, and

the out-of-plane retardation value of the stretched portion of the second phase retardation layer for incident light having the standard wavelength ranges from -130 nm to -50 nm.

15. The method of claim 12, wherein at least one of the first phase retardation layer and the second phase retardation layer comprises at least one of a cyclo-olefin polymer, polyacrylate, polycarbonate, polystyrene, polyethylene terephthalate, and a cellulose-based polymer.


**Patentansprüche**

1. Optische Folie, umfassend:

    eine Polarisationsschicht;
    eine erste Phasenverzögerungsschicht mit einer optischen Achse in einem Winkel im Bereich von 17 Grad bis 27 Grad oder von -27 Grad bis -17 Grad im Verhältnis zu einer Übertragungsachse der Polarisationsschicht; und
    eine zweite Phasenverzögerungsschicht mit einer optischen Achse in einem Winkel im Bereich von 85 Grad bis 95 Grad im Verhältnis zu der Übertragungsachse der Polarisationsschicht;
    wobei die Polarisationsschicht, die erste Phasenverzögerungsschicht und die zweite Verzögerungsschicht der Reihe nach gestapelt sind;
    wobei die erste Phasenverzögerungsschicht einen Verzögerungswert innerhalb der Ebene zwischen 240 nm und 300 nm für einfallendes Licht der Standardwellenlänge von 550 nm aufweist;
    wobei die zweite Phasenverzögerungsschicht einen Verzögerungswert innerhalb der Ebene zwischen 110 nm bis 160 nm für einfallendes Licht der Standardwellenlänge aufweist; und
    wobei ein Verzögerungswert außerhalb der Ebene der ersten Phasenverzögerungsschicht und ein Verzögerungswert außerhalb der Ebene der zweiten Phasenverzögerungsschicht für einfallendes Licht der Standardwellenlänge umgekehrte Vorzeichen aufweisen.

2. Optische Folie nach Anspruch 1, wobei der Verzögerungswert außerhalb der Ebene der ersten Phasenverzögerungsschicht für einfallendes Licht der Standardwellenlänge größer ist als 0 nm und kleiner oder gleich 300 nm, und wobei
    der Verzögerungswert außerhalb der Ebene der zweiten Phasenverzögerungsschicht für einfallendes Licht der Standardwellenlänge größer oder gleich -160 nm und kleiner als 0 nm ist.

3. Optische Folie nach Anspruch 2, wobei der Verzögerungswert außerhalb der Ebene der ersten Phasenverzögerungsschicht für einfallendes Licht der Standardwellenlänge zwischen 130 nm und 250 nm liegt, und wobei
    der Verzögerungswert außerhalb der Ebene der zweiten Phasenverzögerungsschicht für einfallendes Licht der Standardwellenlänge zwischen -130 nm und -50 nm liegt.

4. Optische Folie nach Anspruch 3, wobei die erste Phasenverzögerungsschicht einen Dispersionswert für kurze Wellenlängen zwischen 1,00 und 1,05 aufweist,
    wobei die zweite Phasenverzögerungsschicht einen Dispersionswert für kurze Wellenlängen zwischen 1,00 und 1,20 aufweist;
    wobei die erste Phasenverzögerungsschicht einen Dispersionswert für lange Wellenlängen zwischen 0,95 und 1,00 aufweist,
    wobei die zweite Phasenverzögerungsschicht einen Dispersionswert für lange Wellenlängen zwischen 0,8 und 1,00 aufweist.

5. Optische Folie nach einem der vorstehenden Ansprüche, wobei mindestens die erste Phasenverzögerungsschicht oder die zweite Phasenverzögerungsschicht mindestens eines der folgenden umfasst: ein Cyclo-Olefin-Polymer, Polyacrylat, Polycarbonat, Polystyrol, Polyethylenterephthalat oder ein Polymer auf Zellulosebasis.

6. Optische Folie nach Anspruch 5, wobei die erste Phasenverzögerungsschicht ein Cyclo-Olefin-Polymer umfasst, und wobei die zweite Phasenverzögerungsschicht Polyacrylat umfasst.

7. Optische Folie nach einem der vorstehenden Ansprüche, ferner umfassend eine Passivierungsschicht, die im Verhältnis zu der ersten Phasenverzögerungsschicht entgegengesetzt zu der zweiten Phasenverzögerungsschicht angeordnet ist.

8. Optische Folie nach einem der vorstehenden Ansprüche, wobei
die Polarisationsschicht eine erste Rollfolie aufweist, die sich in eine erste Richtung im Wesentlichen senkrecht zu der Übertragungsachse erstreckt;
die erste Phasenverzögerungsschicht ein zweite Rollfolie aufweist, die sich in die erste Richtung erstreckt, mit einer optischen Achse in einem Winkel im Bereich von 17 Grad bis 27 Grad oder von -27 Grad bis -17 Grad in Bezug auf eine zweite Richtung, senkrecht zu der ersten Richtung, und wobei sie an der ersten Rollfolie angeordnet ist; und wobei
die zweite Phasenverzögerungsschicht eine dritte Rollfolie aufweist, die sich in die erste Richtung erstreckt, mit einer ersten optischen Achse im Bereich von 85 Grad bis 95 Grad in Bezug auf die zweite Richtung, und wobei sie an der zweiten Rollfolie angeordnet ist.

9. Optische Folie nach Anspruch 1, wobei
der Verzögerungswert innerhalb der Ebene der ersten Phasenverzögerungsschicht für die Standardwellenlänge im Bereich von 260 nm bis 280 nm liegt; und
der Verzögerungswert innerhalb der Ebene der zweiten Phasenverzögerungsschicht für die Standardwellenlänge im Bereich von etwa 130 nm bis etwa 140 nm liegt.

10. Optische Folie nach Anspruch 1, wobei:

der Verzögerungswert außerhalb der Ebene der ersten Phasenverzögerungsschicht für die Standardwellenlänge im Bereich von etwa 200 nm bis 230 nm liegt; und
der Verzögerungswert außerhalb der Ebene der zweiten Phasenverzögerungsschicht für die Standardwellenlänge im Bereich von etwa -120 nm bis etwa -90 nm liegt.

11. Anzeigevorrichtung, umfassend:

ein Anzeigefeld; und
eine optische Folie nach einem der vorstehenden Ansprüche, die sich auf dem Anzeigefeld befindet.

12. Verfahren zur Herstellung einer optischen Folie, wobei das Verfahren folgendes umfasst:

Entrollen einer Polarisationsschicht, einer ersten Phasenverzögerungsschicht und einer zweiten Phasenverzögerungsschicht;
Fortführen entrollter Abschnitte der Polarisationsschicht, der ersten Phasenverzögerungsschicht und der zweiten Phasenverzögerungsschicht in eine Fortführungsrichtung; und
Bewegen der fortführenden Abschnitte der Polarisationsschicht, der ersten Phasenverzögerungsschicht und der zweiten Phasenverzögerungsschicht zum Stapeln näher aneinander;
wobei die Polarisationsschicht in die Fortführungsrichtung gestreckt wird;
wobei die erste Phasenverzögerungsschicht in eine Richtung gestreckt wird, die einen Winkel von 63 Grad bis 73 Grad oder -73 Grad bis -63 Grad zu der Fortführungsrichtung bildet;
wobei die zweite Phasenverzögerungsschicht in eine Richtung gestreckt wird, die einen Winkel von -5 Grad bis 5 Grad zu der Fortführungsrichtung bildet; und
wobei ein Verzögerungswert außerhalb der Ebene eines gestreckten Teils der ersten Phasenverzögerungsschicht bei einer Standardwellenlänge von etwa 550 Nanometern und ein Verzögerungswert außerhalb der Ebene eines gestreckten Teils der zweiten Phasenverzögerungsschicht für die Standardwellenlänge umgekehrte Vorzeichen aufweisen.

13. Verfahren nach Anspruch 12, wobei der Verzögerungswert außerhalb der Ebene des gestreckten Teils der ersten Phasenverzögerungsschicht für einfallendes Licht der Standardwellenlänge größer als 0 nm und kleiner oder gleich 300 nm ist; und
wobei der Verzögerungswert außerhalb der Ebene des gestreckten Teils der zweiten Phasenverzögerungsschicht für einfallendes Licht der Standardwellenlänge größer oder gleiche -160 nm und kleiner als 0 nm ist.

14. Verfahren nach Anspruch 13, wobei der Verzögerungswert außerhalb der Ebene des gestreckten Teils der ersten Phasenverzögerungsschicht für einfallendes Licht der Standardwelle zwischen 130 nm und 250 nm liegt; und
wobei der Verzögerungswert außerhalb der Ebene des gestreckten Teils der zweiten Phasenverzögerungsschicht für einfallendes Licht der Standardwellenlänge zwischen -130 nm und -50 nm liegt.

**15.** Verfahren nach Anspruch 12, wobei mindestens die erste Phasenverzögerungsschicht oder die zweite Phasenverzögerungsschicht mindestens eines der folgenden umfasst: ein Cyclo-Olefin-Polymer, Polyacrylat, Polycarbonat, Polystyrol, Polyethylenterephthalat oder ein Polymer auf Zellulosebasis.

**Revendications**

**1.** Film optique comprenant :

une couche de polarisation ;
une première couche retardatrice de phase ayant un axe optique à un angle compris entre 17 et 27 degrés ou entre -27 et -17 degrés par rapport à un axe de transmission de la couche de polarisation ; et
une seconde couche retardatrice de phase ayant un axe optique à un angle compris entre 85 et 95 degrés par rapport à l'axe de transmission de la couche de polarisation,
dans lequel la couche de polarisation, la première couche retardatrice de phase, et la seconde couche retardatrice de phase sont empilées dans l'ordre,
la première couche retardatrice de phase a une valeur de retard en plan de 240 à 300 nm pour la lumière incidente ayant une longueur d'onde standard de 550 nm,
la seconde couche retardatrice de phase a une valeur de retard en plan de 110 à 160 nm pour la lumière incidente ayant la longueur d'onde standard, et
une valeur de retard hors plan de la première couche retardatrice de phase et une valeur de retard hors plan de la seconde couche retardatrice de phase pour la lumière incidente ayant la longueur d'onde standard ont des signes opposés.

**2.** Film optique selon la revendication 1, dans lequel la valeur de retard hors plan de la première couche retardatrice de phase pour la lumière incidente ayant la longueur d'onde standard est supérieure à 0 nm et inférieure ou égale à 300 nm, et
la valeur de retard hors plan de la seconde couche retardatrice de phase pour la lumière incidente ayant la longueur d'onde standard est égale ou supérieure à -160 nm et inférieure à 0 nm.

**3.** Film optique selon la revendication 2, dans lequel la valeur de retard hors plan de la première couche retardatrice de phase pour la lumière incidente ayant la longueur d'onde standard est comprise entre 130 et 250 nm, et
la valeur de retard hors plan de la seconde couche retardatrice de phase pour la lumière incidente ayant la longueur d'onde standard est comprise entre -130 et -50 nm.

**4.** Film optique selon la revendication 3, dans lequel la première couche retardatrice de phase a une valeur de dispersion de longueur d'onde courte comprise entre 1,00 et 1,05,
la seconde couche retardatrice de phase a une valeur de dispersion de longueur d'onde courte comprise entre 1,00 et 1,20,
la première couche retardatrice de phase a une valeur de dispersion de longueur d'onde longue comprise entre 0,95 et 1,00, et
la seconde couche retardatrice de phase a une valeur de dispersion de longueur d'onde longue comprise entre 0,85 et 1,00.

**5.** Film optique selon l'une quelconque des revendications précédentes, dans lequel au moins une de la première couche retardatrice de phase et de la seconde couche retardatrice de phase comprend au moins l'un parmi un polymère de cyclo-oléfine, polyacrylate, polycarbonate, polystyrène, poly(téréphtalate d'éthylène), et polymère à base de cellulose.

**6.** Film optique selon la revendication 5, dans lequel la première couche retardatrice de phase comprend un polymère de cyclo-oléfine, et la seconde couche retardatrice de phase comprend un polyacrylate.

**7.** Film optique selon l'une quelconque des revendications précédentes, comprenant en outre une couche de passivation disposée à l'opposé de la seconde couche retardatrice de phase par rapport à la première couche retardatrice de phase.

**8.** Film optique selon l'une quelconque des revendications précédentes, dans lequel
la couche de polarisation comprend un premier film en rouleau s'étendant dans une première direction sensiblement perpendiculaire à l'axe de transmission,
la première couche retardatrice de phase comprend un deuxième film en rouleau s'étendant dans la première direction, ayant un axe optique à un angle compris entre 17 et 27 degrés ou entre -27 et -17 degrés par rapport à une seconde direction perpendiculaire à la première direction, et disposé sur le premier film en rouleau, et la seconde couche retardatrice de phase comprend un troisième film en rouleau s'étendant dans la première direction, ayant un axe optique à un angle compris entre 85 et 95 degrés par rapport à la seconde direction, et disposé sur le deuxième film en rouleau.

**9.** Film optique selon la revendication 1, dans lequel
la valeur de retard en plan de la première couche retardatrice de phase à la longueur d'onde standard est comprise entre 260 et 280 nm, et
la valeur de retard en plan de la seconde couche retardatrice de phase à la longueur d'onde standard est comprise entre environ 130 et environ 140 nm.

**10.** Film optique selon la revendication 1, dans lequel
la valeur de retard hors plan de la première couche retardatrice de phase à la longueur d'onde standard est comprise entre environ 200 et environ 230 nm, et
la valeur de retard hors plan de la seconde couche retardatrice de phase à la longueur d'onde standard est comprise entre environ -120 et environ -90 nm.

**11.** Dispositif d'affichage comprenant :

un panneau d'affichage ; et
un film optique selon l'une quelconque des revendications précédentes, disposé sur le panneau d'affichage.

**12.** Procédé de fabrication d'un film optique, le procédé comprenant les étapes consistant à :

dérouler des rouleaux d'une couche de polarisation, d'une première couche retardatrice de phase, et d'une seconde couche retardatrice de phase ;
faire avancer des parties déroulées de la couche de polarisation, de la première couche retardatrice de phase, et de la seconde couche retardatrice de phase dans une direction d'avance ; et
rapprocher les parties précédentes de la couche de polarisation, de la première couche retardatrice de phase, et de la seconde couche retardatrice de phase les unes des autres pour les empiler,
dans lequel la couche de polarisation est étirée dans la direction d'avance,
la première couche retardatrice de phase est étirée dans une direction faisant un angle compris entre 63 et 73 degrés ou entre -73 et -63 degrés par rapport à la direction d'avance,
la seconde couche retardatrice de phase est étirée dans une direction faisant un angle compris entre -5 et 5 degrés par rapport à la direction d'avance, et
une valeur de retard hors plan d'une partie étirée de la première couche retardatrice de phase à une longueur d'onde standard d'environ 550 nanomètres et une valeur de retard hors plan d'une partie étirée de la seconde couche retardatrice de phase à la longueur d'onde standard ont des signes opposés.

**13.** Procédé selon la revendication 12, dans lequel la valeur de retard hors plan de la partie étirée de la première couche retardatrice de phase pour la lumière incidente ayant la longueur d'onde standard est supérieure à 0 nm et inférieure ou égale à 300 nm, et
la valeur de retard hors plan de la partie étirée de la seconde couche retardatrice de phase pour la lumière incidente ayant la longueur d'onde standard est égale ou supérieure à -160 nm et inférieure à 0 nm.

**14.** Procédé selon la revendication 13, dans lequel la valeur de retard hors plan de la partie étirée de la première couche retardatrice de phase pour la lumière incidente ayant la longueur d'onde standard est comprise entre 130 et 250 nm, et
la valeur de retard hors plan de la partie étirée de la seconde couche retardatrice de phase pour la lumière incidente ayant la longueur d'onde standard est comprise entre -130 et -50 nm.

**15.** Procédé selon la revendication 12, dans lequel au moins une de la première couche retardatrice de phase et de la seconde couche retardatrice de phase comprend au moins l'un parmi un polymère de cyclo-oléfine, polyacrylate, polycarbonate, polystyrène, poly(téréphtalate d'éthylène), et polymère à base de cellulose.

FIG. 1

10

12

13

FIG. 2

FIG. 3

FIG. 4

FIG. 5

140

- 190
- 150
- 180
- 160
- 170

# FIG. 6

300

322
324
326
328
320

310

FIG. 7

400

# EP 2 662 712 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 20080071150

### Non-patent literature cited in the description

- **CHAO-TE LEE et al.** Designs of broadband and wide-view patterned polarizers for stereoscopic 3D displays. *OPTICS EXPRESS,* 20 December 2010, vol. 18 (26), 27079